# EUROPEAN PATENT SPECIFICATION

(11) **EP 0 531 428 B1**
(45) Date of publication and mention of the grant of the patent: **13.08.1997**
(21) Application number: 91911016.3
(22) Date of filing: 24.05.1991
(51) Int. Cl.: H04N 7/00, G01R 15/12, G01R 1/067

(54) **TEST FIXTURE ALIGNMENT APPARATUS AND METHOD**
AUSRICHTSYSTEM UND -VERFAHREN FÜR EINE PRÜFHALTERUNG
SYSTEME D'ALIGNEMENT AVEC UN DISPOSITIF D'ESSAI ET PROCEDE CORRESPONDANT

(30) Priority: 25.05.1990 US 528957; 31.01.1991 US 648453
(43) Date of publication of application: 17.03.1993
(73) Proprietor: EVERETT/CHARLES CONTACT PRODUCTS INC., Pomona California 91767 (US)
(72) Inventor: SWART, Mark, A., Upland, CA 91786 (US); JOHNSTON, Charles, J., Walnut, CA 91789 (US); VAN LOAN, David, R., Diamond Bar, CA 91765 (US)
(74) Representative: Grünecker, Kinkeldey, Stockmair & Schwanhäusser Anwaltssozietät
(86) International application number: US9103688
(87) International publication number: WO9119392

(56) References cited:
- EP-A- 0 351 174
- GB-A- 2 085 673
- US-A- 3 651 401
- US-A- 4 668 982
- US-A- 4 820 975
- US-A- 4 922 434
- US-A- 4 943 767
- US-A- 4 962 423

## Description

The invention relates to a test fixture for testing a printed circuit board in which the test fixture comprises a base; an array of test probes on the base to be aligned with a pattern of test points in a circuit array on the board, the circuit array being positioned on the board with reference to one or more indexing marks on the board, said indexing marks comprising a fiducial mark; and board mounting means on the board for holding the board in a fixed position relative to the array of test probes on the base, sensing means for sensing the position of the fiducial mark on the board as the board is held on the base by the board mounting means, to produce a measurement of the alignment or misalignment of the array of test probes relative to a pattern of test points in the circuit array on the board.

In the automatic testing of printed circuit boards, conventional spring-loaded test probes are typically mounted on a test fixture, and the circuit board under test is held in pressure contact with the spring probes to provide electrical contact between diagnostic or testing equipment and circuits on the board under test. Each test fixture typically contains a base or probe plate having an array of spring probes dedicated to the board under test. Identical circuit boards are then aligned with the fixture and tested, one at a tine, to determine whether there are any defects in the circuits printed on each board.

During testing, the spring probes must be correctly aligned with test points in the circuits printed on the board under test. This requires correct alignment of the board on the fixture so that the spring probes are automatically registered with corresponding test points in the circuit array printed on each board. In order to align the board with the probes, the customary practice has been to first drill tooling pin holes in the circuit board. Drilling is done by the board manufacturer, and usually a pair of tooling pin holes are drilled in diagonally opposite corners of the board. During testing, tooling pins in opposite corners of the fixture are positioned in corresponding tooling pin holes to automatically align the board with the array of test probes on the fixture. This procedure requires that the tooling pin holes be drilled accurately in the board by the board manufacturer, so that when each board is later mounted on the tooling pins, the test probes will automatically register with the circuits printed on the board when the test probes are brought into pressure contact with the board during testing.

Printed circuit boards made by a given manufacturer are usually produced in lots, and boards within a given lot will tend to produce a certain misalignment, from tolerance error, when boards within that lot are mounted on a fixture. Alignment tolerances will tend to vary from lot to lot with a given manufacturer. The same board made by a different manufacturer also tends to have different tolerance variations and misalignment errors from lot to lot.

Printed circuit boards typically have a pair of "fiducial marks" printed in the margin of the board at known reference positions relative to the circuit array or "artwork" printed on the board. The fiducial marks are printed on the board by the board manufacturer, and the fiducial marks are used as a guide for the manufacturer's drilling of the tooling pin holes at locations on the board that will automatically align (hopefully) the board to the test probes when the board is mounted on the tooling pins.

There are drawbacks to using these procedures for aligning a printed circuit board with a test fixture. Mechanical tolerances are involved in (1) positioning of the drilling tool in the drilling machine, (2) positioning of the tooling pin holes drilled in the printed circuit board with respect to the artwork on the board, and (3) positioning of the tooling pins on the fixture with respect to the tooling pin holes in the board. Because of these tolerance accumulations, the test probes often do not precisely register with the test points in the circuit array printed on the board. This problem is magnified by tolerance variations in board lots from different manufacturers. The problem also is compounded by advances in the art of printed circuit board technology, where printing of circuits with finer lines and narrower circuit spacings requires more accurate registration of the test probes with the circuits under test. At the present time, for example, it is common for test probes to be misaligned within a range of 0.005 to 0.008 inch in a typical test fixture; more accurate alignment is desirable, and the present invention provides techniques for achieving greater alignment accuracy.

In order to overcome the above-mentioned problems, a test fixture of the afore-mentioned kind is known from US patent number US-A-4 820 975. The test fixture disclosed therein includes two test heads, one for each side of the board. Each test head carries an array of spring-loaded probes for making electrical contact with the pads on the printed circuit board. Each head also includes two optical fibre image guides for viewing alignment marks at diagonally opposite corners of the printed circuit board, so as to indicate the degree of misalignment between the head and the printed circuit board. The alignment can be adjusted by means of linear drive mechanisms which allow the position of the head to be adjusted in two-dimensions relative to the printed circuit board. However, the test fixture as disclosed in US patent number US-A-4 820 975 is complex in design and expensive to manufacture.

A similar device is known from GB-A-2085673. Said device comprises an array of contact pins arranged in spaced relationship on a carrier member and an array of spaced contact surfaces individually electrically connectable to an electrical measuring instrument, wherein in use are selected tips of said pins are brought into contact with appropriate test locations on a circuit board and base portions of said selected pins are brought into contact with corresponding ones of said contact surfaces, whereby said test locations are electrically connected to said measuring instrument. In order to adjust the tips of the pins to said test location on the circuit board, the carrier member can be moved laterally in two dimensions.

The object of the invention is to overcome the limitations and drawbacks of the devices according to the prior art.

This object is achieved by sensing means being mounted in a fixed position on the base for sensing the position of the fiducial mark on the board, and that the board mounting means comprises a tooling pin on the fixture for engaging and alignment device positioned on the board and in alignment with the circuit array to hold the board and the circuit array in a fixed position relative to the array of test probes on the fixture and means for rigidly securing the tooling pin in a first position for holding the board in a fixed position to produce said sensing means measurement, the tooling pin being moveable relative to the fixed position of the sensing means to move the board relative to the array of test probes to a second adjusted position to correct any misalignment of the circuit array relative to the array of test probes and to produce a corresponding change in said sensing means measurement, said sensing means producing said output to indicate the precise movement of the board to the second adjusted position on the fixture necessary to align the sensing means with the fiducial mark, to thereby indicate precise alignment of the test probes with corresponding test points in a circuit array on the board.

The test fixture according to the present invention provides a system for accurately positioning a printed circuit board on a test fixture so that a pattern of test points in a circuit array printed on the board is precisely registered in an array of corresponding test probes on the fixture. Advantages of the test fixture according to the present invention includes its ability to produce extremely accurate alignment quickly and easily, low manufacturing costs, reduced time and cost involved in the internal alignment (calibration) of the fixtures system components, and interchangeability with different fixtures.

In a different embodiment it can be advantageous, if the sensing means comprise an optical fibre sensor, further including a visual display responsive to an optical fibre sensor output for producing a visual display of said measurement. The sensing means may comprise a camera lens and video probe assembly; and means responsive to an output of the video probe assembly for producing a visual reading of said measurement; and in which the visual reading is produced by means converting an output of the video probe to a video image representative of said alignment or misalignment.

In the camera lens a video probe may be removable mounted on the fixture base.

An enlarged image of the indexing mark may be displayed on a video monitor for comparison with an electronically adjustable indexing mark produced on the monitor to indicate the correct alignment position of the circuit array relative to the probes.

It may further be advantageous, if an enlarged image of the fiducial mark is displayed on a video monitor for comparison with an adjustable indexing mark electronically produced on the monitor to indicate the correct alignment position of the probes relative to the circuit array.

The board mounting means may also comprise a tooling pin mounting hole in the fixture base adapted to provide substantially 360° freedom of movement of the tooling pin relative to the sensing means on the fixture base, and locking means adapted to hold the tooling pin in a fixed adjusted position on the fixture base in the tooling pin hole.

Sensing means may comprise an image focusing and enlarging means which are removably mounted to fixed position on the fixture base.

In a different embodiment of the present invention, in which the board mounting means comprise a tooling pin on the fixture base for engaging and alignment device on the board to hold the board in its circuit array in a fixed position relative to the array of test probes on the fixture base, sensing means may comprise an optical fibre means mounted in a fixed position on the fixture base for sensing the indexing mark on the board and producing a first image that represents the position of the indexing mark, means for producing a second image of the fixed reference point may be provided that represent a fixed reference position with which indexing mark position can be aligned to correctly register the array of test probes with the pattern of test points on the board, electrical control means for forming the second image on a monitor may be provided and for adjusting the position of the second image on the monitor to indicate a calibrated correct alignment of the test probes relative to the circuit array on the board, the tooling pin may be visually held in said first position to hold the board in its position when producing said first image, the tooling pin may be movable to said second adjusted position, to thereby move the board relative to the fixture to align the first and second images and thereby correctly align the array of test probes with the pattern of test points.

The sensing means may comprise optical image conduits, mounted in fixed positions spaced apart on a fixture for producing an image of each indexing mark on the board; and may include video means aligned with each optical image conduit for producing separate enlarged video images of each indexing mark and a video monitor when the board is in said fixed position; and electrical control means by be provided for independently adjusting the positions of corresponding fixed reference points displayed on a video monitor for representing correct alignment of the test probes relative to the test points on the board; the positions of the board mounting means on the base may be adjustable to move the printed circuit board relative to the fixture base and relative to the fixed position of the optical image conduit thereon to move the board to a corrected position to thereby move the images of the fiducial marks to alignment with said corresponding fixed reference points, thereby aligning the test points on the board with corresponding test probes on the fixture.

The video means of the test fixture may also include a video camera and a video cable for transmitting electronic video image signals from each video camera to a video monitor, and a separate reference point generator having a signal input to the video cable for superimposing an image of the reference point on the video monitor for adjustable alignment with the image of the fiducial mark produced by the video camera.

The present invention also provides a method of testing a printed circuit board having an array of test points in a circuit array aligned on the board with reference to a fiducial mark on the board as set out in claim 12.

According to the method, the optical image may be produced by an optical fibre image conduit.

The optical image may be produced by a lens system for focusing on the fiducial mark and forming an enlarged image of the fiducial mark.

A method according to the present invention may also include a step of calibrating the fixed reference indication by electronically adjusting the position of the reference indicator on a monitor and then moving the fiducial mark image into alignment with the fixed reference indication.

FIG. 1 is a perspective view illustrating a test fixture with an adjustable alignment system according to principles of this invention.

FIG. 2 is a fragmentary cross-sectional view illustrating an adjustable tooling pin mounted on the fixture.

FIG. 3 is a top view taken on line 3-3 of FIG. 2.

FIG. 4 is a cross-sectional view taken on line 4-4 of FIG. 5 and showing a locking nut for the adjustable tooling pin.

FIG. 5 is a top view of the locking nut.

FIG. 6 is a diagrammatic representation of means for adjusting the tooling pin and means for locking the tooling pin with the locking nut.

FIG. 7 is a schematic diagram illustrating components of an optical system for amplifying and displaying means for aligning a circuit board with test probes on the fixture.

FIG. 8 is a schematic representation illustrating visual indications of indexing means for use in aligning the printed circuit board to the fixture.

FIG. 9 is a fragmentary cross-sectional view illustrating one embodiment of a test fixture containing an optical test fixture alignment system.

FIG. 10 is a fragmentary cross-sectional view illustrating an alternative embodiment of the test fixture containing a video camera in an optical test fixture alignment system.

FIG. 11 is a fragmentary cross-sectional view similar to FIG. 10, but showing the fixture rotated to an open position.

FIG. 12 is a semi-schematic cross-sectional view illustrating components of a miniature video camera system for imaging test fixture alignment.

FIG. 13 is an elevation view taken along 13-13 of FIG. 12.

FIG. 14 is a schematic functional block diagram illustrating electronic components of the test fixture alignment imaging system.

FIG. 15 is a perspective view illustrating an alternative technique for aligning a circuit board with a test fixture.

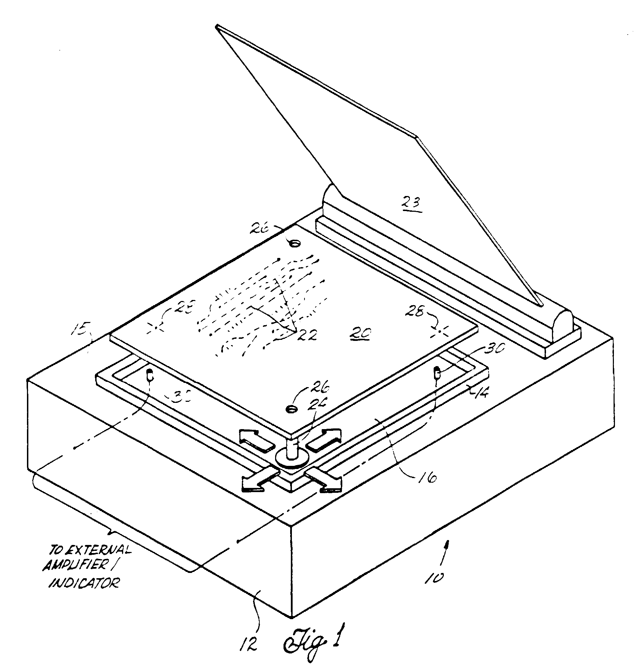

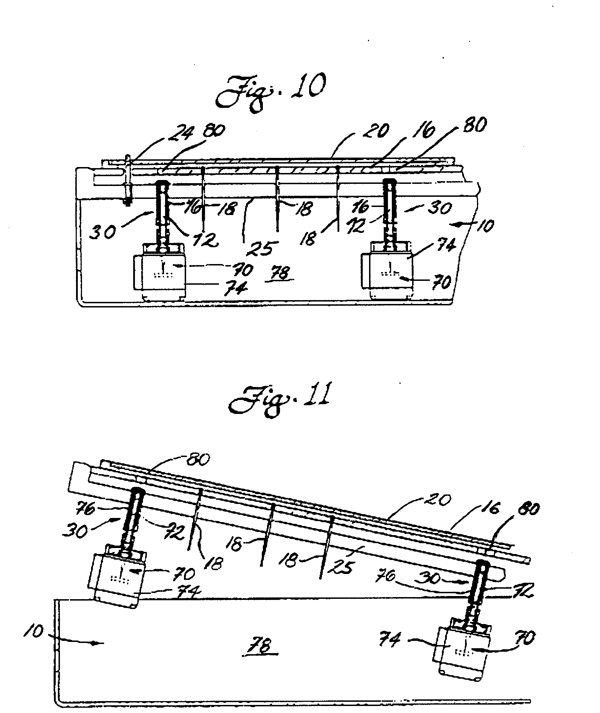

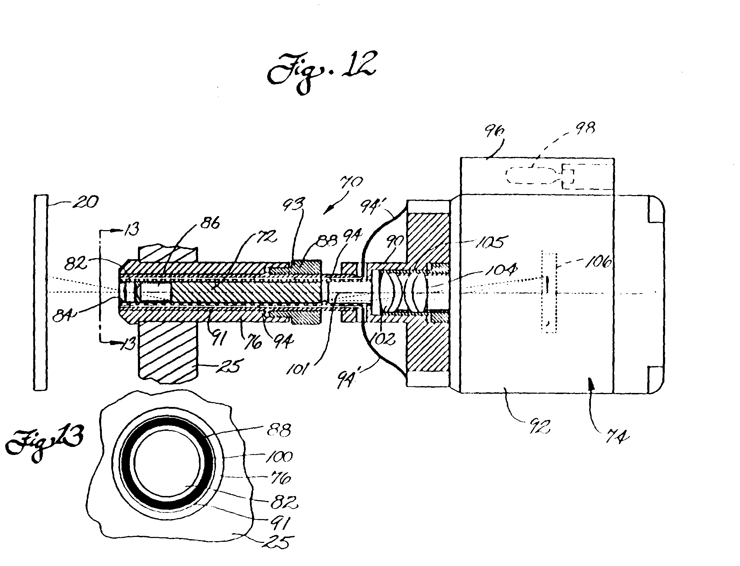

FIG. 1 illustrates a test fixture 10 which can represent any test fixture of the type used in the automatic testing of printed circuit boards. In the illustrated embodiment, the fixture includes a housing 12 and a rectangular compressible gasket 14 mounted on an upper face 15 of the housing. The rectangular gasket mounts a circuit board 20 to the fixture and defines the exterior peripheral boundary of a region within the fixture that mounts an array of spring-loaded test probes 18. The probes are represented schematically in FIG. 7 and are also shown in FIGS. 9-11. The test probes are mounted in a desired pattern on a probe plate 25 within the fixture to match the pattern of test points in circuits printed on the circuit board 20 under test. The printed circuit board includes a printed circuit array 22 formed by conventional artwork techniques. In the illustrated embodiment, the circuit array 22 is printed on an underside of the board which faces an array of test probes that project through holes in a movable top plate 16. The gasket 14 is mounted to the top of the moving top plate 16 as shown best in FIG. 9. The moving top plate holds the circuit board 20 parallel the array of test probes. Individual test points within the circuit array 22 on the board are contacted by corresponding test probes during automatic testing of the circuits on the board.

In a preferred test fixture arrangement, the probe plate 25 and the moving top plate 16 are drilled with holes on a pattern that matches the test points in the circuit array on the board under test. The test probes are then mounted in the pattern of holes on the probe plate. The test probes project up through the holes in the moving top plate 16, which is spring-mounted to the probe plate 25. The drilled probe plate and the top plate are dedicated to a particular board under test, and identical circuit boards are tested one-by-one on the fixture. To test a different circuit board, a new probe plate and moving top plate are drilled with a new hole pattern, and a new array of probes are used for testing the board on what otherwise is the same fixture.

Although the invention is described with reference to circuit boards having an array of printed circuits, such as "bare boards" as they are known in the art, the fixture alignment system of this invention also can be used for testing "loaded circuit boards" to which circuit components, such as integrated circuit packages and the like, are mounted.

Once the printed circuit board 20 is mounted on the fixture, a hinged door 23 is closed over a cavity containing the circuit board, and vacuum pressure is applied to resiliently bias the spring probes into contact with corresponding test points in the circuit array printed on the board, in a manner familiar to those skilled in the art. A typical means of applying pressure can be through vacuum applied to the cavity to seal the board 20 to the gasket 14 during testing. The vacuum draws the board and the moving top plate 16 down toward the array of test probes 18 on the probe plate 25. Continuity or lack of continuity between the various test points in the electrical circuits on the board are detected by an external electronic test analyzer (not shown) electrically coupled to the test probes for use in measuring whether the circuit board is functional or for identifying defective circuits.

During testing, a pair of movable tooling pins 24 mounted in diagonally opposite corners of the probe plate 25 are registered with corresponding tooling pin holes 26 drilled in diagonally opposite corners of the circuit board 20. (Only one of the movable tooling pins is shown in FIG. 1; the other is obscured by the printed circuit board.) By positioning the tooling pins in the tooling pin holes, the board is mounted in a fixed position parallel to the fixture base, so that the test points in the circuit array 22 can be automatically with corresponding test probes 18 for testing the circuits on the board. Use of tooling pins inserted in the tooling pin holes is one example of a means for mounting the board to the fixture. Alternatively, tooling pins on the fixture can be engaged with other alignment devices on the board to hold the board in a fixed position as the fixture. On example is a tooling pin with a right angle recess that engages a right angle corner of a board. Other means of aligning the board to the fixture are possible.

As mentioned previously, the tooling pins do not necessarily produce the desired precise alignment. The tooling pin holes are drilled in the board by the board manufacturer. Fiducial marks 28 are printed on the board by the board manufacturer, and these marks, shown in diagonally opposite corners of the board, provide a known reference point or indexing mark with respect to the artwork printed on the board. (The fiducial marks shown on the top side of the board in FIG. 1 are actually visible from the underside of the board.) The board manufacturer aligns the drilling tools with respect to the artwork on the board, using the fiducial marks as a reference, and the tooling pin holes are positioned (drilled) on the board with reference to the fiducial marks. However, in practice, mechanical tolerance accumulations are generated from positioning the board in the drilling machine, positioning the drilling tools in the drilling machine, drilling the tooling pin holes, and registering the tooling pins on the fixture with the drilled tooling pin holes. Thus, the tooling pin holes drilled in the board may not precisely register the spring probes with the artwork on the board when the tooling pins are inserted in the tooling pin holes and the board is brought into pressure contact with the probes.

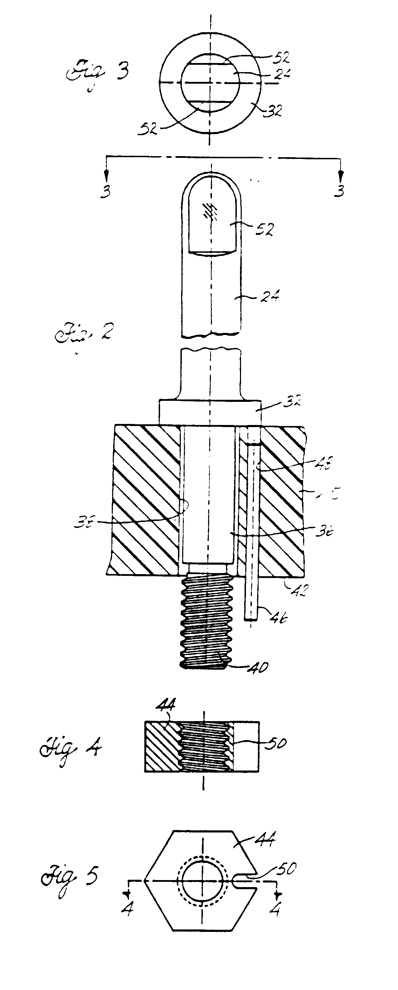

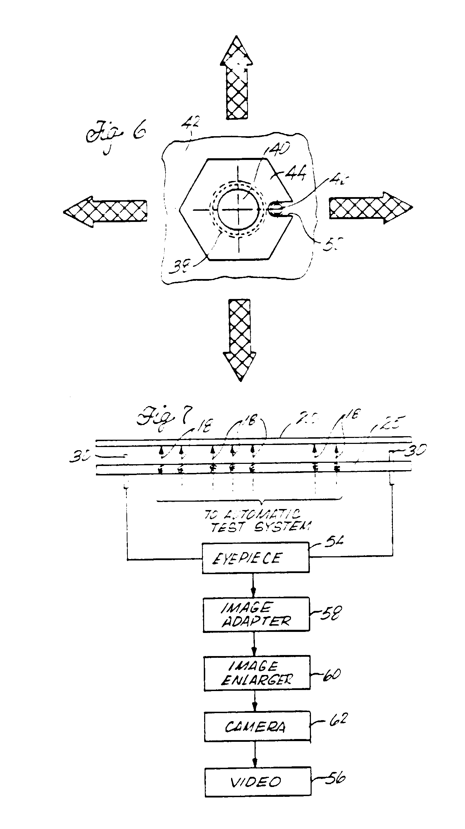

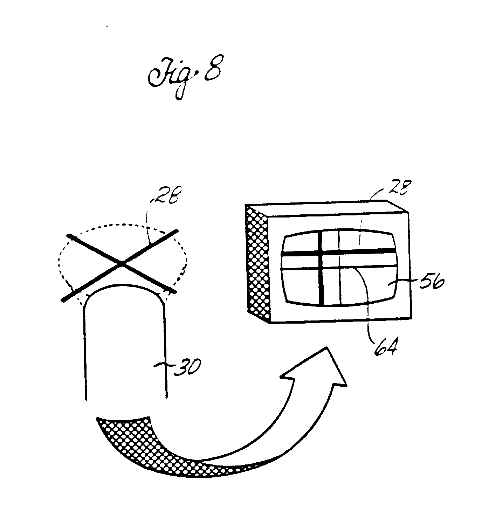

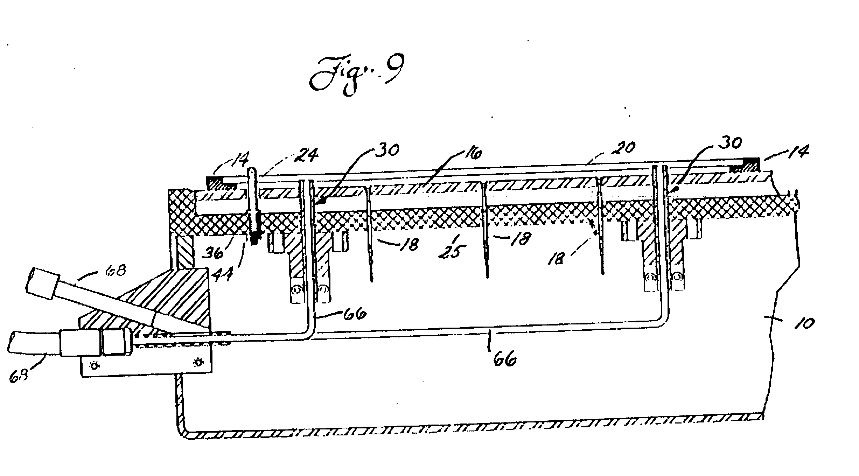

The fixture 10 provides means for overcoming the drawbacks of the conventional practice of aligning a circuit board under test with a test fixture. The fixture 10 includes an alignment system having a means for movably positioning the tooling pins 24 on the probe plate 25, together with sensors 30 on the probe plate for use in sensing the position of the fiducial marks 28 on the board under test. The movable tooling pins allow the board to be moved manually relative to the probe field on the fixture. The sensors detect movement of the fiducial marks as the printed circuit board is moved into alignment with the probe field, and an enlarged image of each fiducial mark is displayed to assist in precise manual alignment of the board to the probes on the fixture. The fiducial marks are sensed by the sensors 30, and images of the marks are produced and are observable in relation to an image of a corresponding known zero reference point used as a reference index in an optical alignment and display system. The tooling pins 24 are manually movable to move the board while observing corresponding movement of the fiducial mark on the display, so the board can be moved to accurately align each fiducial mark 28 with a displayed reference point. This movement automatically positions the test points in the circuit array 22 in precise alignment with corresponding spring probes on the fixture base. FIGS. 2 through 6 illustrate a preferred system for adjustably mounting the tooling pins to the fixture base. Separately, the sensors 30 are mounted in fixed positions on the fixture base in diagonally opposite corners and in alignment with the fiducial marks 28 or any other indexing marks of the board under test. The sensors 30 and the reference indexing and optical alignment system are described in more detail below.

Referring now to FIGS. 2 through 6, adjustment of the tooling pin positions will now be described. Each tooling pin 24 comprises a rounded upright board-locating pin with an enlarged rounded base 32 having a flat annular bottom surface 34. The diameter of the tooling pin matches the diameter of the tooling pin hole drilled in the board so the board can be positioned on the tooling pin. An elongated cylindrical shank portion 36 of a pin fastening member extends downwardly from the underside of the rounded base 32. The shank has an outside diameter similar to the outside diameter of the tooling pin, and the axis of the shank is aligned with the vertical axis through the tooling pin. The shank is positioned in a mounting hole 38 in the probe plate or fixture base 25. The mounting hole is oversized relative to the outside diameter of the shank, so the shank portion of the locating pin can have 360° freedom of movement within the fixture hole. During this movement, the rounded base 32 of the locating pin completely covers the hole and provides a support base for holding the tooling pin at all times in a vertical upright position. The bottom of the pin fastening member has an externally threaded section 40 that projects down from a bottom face 42 of the fixture base. The tooling pin is held in place in the fixture base by an internally threaded locking nut 44 tightened onto the externally threaded bottom section 40 of the fastening system. By rotating the locking nut onto the projecting bottom portion of the fastening member during assembly, the tooling pin can be held in a fixed orientation with respect to the top plane of the fixture base.

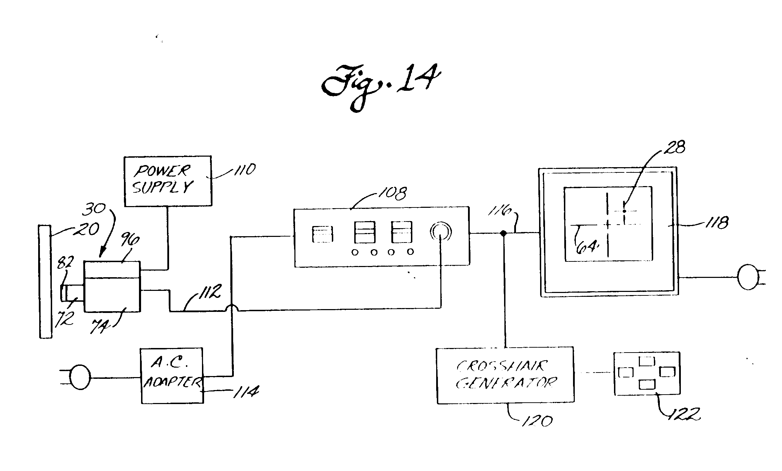

During assembly, and after the locking nut has been tightened against the bottom face of the fixture, a dowel pin 46 is then placed in a narrow passageway 48 in the fixture bottom adjacent the shank portion 36 of the tooling pin 24. The dowel pin is preferably adhesively bonded or otherwise rigidly affixed in the passageway to hold the dowel pin in a fixed position, with a lower portion of the dowel pin projecting from the bottom face 42 of the fixture base, adjacent the locking nut 44. The projecting lower portion of the dowel pin is contained within a narrow recess 50 in the locking nut. The tooling pin 24 is movable relative to the fixture base by engaging the flats on a wrench (not shown) with flats 52 at the top of the tooling pin, and by turning the wrench to rotate the tooling pin about its axis. This loosens the tooling pin from its fastened connection to the locking nut and allows the entire tool pin assembly to be moved in any direction within the hole 38 relative to the fixture base. Once the tooling pin has been moved to a desired position, the tooling pin then can be locked to the base by turning the tooling pin, using the wrench applied to the flats 52 from access provided above the fixture base. The dowel pin 46 engages the recess 50 in the locking nut 44 to prevent rotation of the locking nut as the tooling pin is being tightened to its locked position. The upper portion of the tooling pin 24 extends through an oversized hole in the top plate 16 (see FIGS. 9 and 10) so the tooling pin can be moved on the fixture base (probe plate 25) without moving the top plate when the board is moved.

Alignment of the printed circuit board to the array of test probes will now be described. The sensors 30 comprise any type of sensing device that can sense the location of the fiducial marks 28 on the board and provide an output signal representative of the sensed position of the fiducial marks. Since the fiducial marks are printed at known reference positions relative to the artwork printed on the board, the fiducial marks provide a precise reference point with respect to the locations of the test points within the circuit array printed on the board. The sensors 30 preferably comprise optical sensors which optically sense the positions of the fiducial marks and produce an output which is processed by an external image enlarger and display system that amplifies and displays enlarged images of the positions of the fiducial marks relative to corresponding known zero reference points which are also displayed.

In a preferred alignment technique, a known zero reference is first established. Preferably, a reference board known as a "gold board" is used to set the zero reference. The gold board is a replica of a printed circuit board having its fiducial marks (or other indexing marks) perfectly set to positions on the board with reference to the position of the artwork on the board. The gold board preferably has two fixture pins, referred to as "gold pins," in its opposite corners to represent the perfectly set fiducial marks. The gold board also has fixed tooling pins positioned on the gold board for perfect alignment of the gold board to the fixture. The gold board is mounted on the fixture by inserting the tooling pins of the gold board into fixed tooling pin holes on the fixture, which correctly aligns the gold board to the fixture. This produces perfect alignment of the fiducial marks (the gold pins) on the gold board with the fixture and its probe field. (The gold board has clearance holes for receiving the movable tooling pins 24 so the gold board can be mounted to the fixture independently of the location of the tooling pins 24. No circuits are printed on the gold board since the gold board is used only for alignment purposes.) The sensors 30 are then used for sensing the positions of each gold pin and displaying an enlarged image of the gold pin on a display or monitor. The images of the gold pins are preferably displayed on separate monitors, although they could be displayed together on one monitor. Separately, a cross-hair generator is used to form a cross-hair image on the display to represent a perfect zero alignment of the board to the fixture. A separate cross-hair image is superimposed over the image of each gold pin displayed on the monitor. The optical sensing system is then aligned to the gold pins on the gold board using the images displayed on the monitor. The gold board remains fixed with respect to the fixture and the images of the cross-hairs are moved electronically until each cross-hair registers perfectly with the enlarged image of a corresponding gold pin displayed on the monitor. This precisely aligns the image display system to each fiducial mark (the gold pins) on the gold board, so that the settings of the cross-hair zero points represent perfect alignment of the artwork on the circuit board related back to the probe field on the fixture. The gold board is then removed from the fixture. Thereafter, circuit boards placed on the fixture tooling pins are aligned with the zero-tolerance-error reference points represented by the images of the cross-hairs on the monitor. When a circuit board is first placed on the fixture, any misalignment of the artwork relative to the probe field is represented by a misalignment of each fiducial mark relative to its corresponding cross-hair zero point that represents zero tolerance error. The movable tooling pins are then loosened, the board is moved manually, and the monitor is observed to align each sensed fiducial mark with its corresponding cross-hair reference. This automatically and precisely aligns the artwork on the board to the array of probes on the fixture.

The separate calibration board (gold board) and electronically adjustable cross-hair generator calibrate alignment of the fixed zero reference point to the fiducial mark imaging system, independently of system optics. This greatly reduces the cost of the alignment system when compared with a system in which the fixed reference is built into a lens system for imaging the fiducial mark.

The optical sensors 30 can be in various forms. In one embodiment, each sensor may comprise an optical fiber sensor. (Other sensing devices are described below.) A preferred optical fiber sensor comprises a coaxial optical fiber sensor having a monofilament optical fiber core, and a separate outer optical fiber tube made of a bundle of tiny optical fibers positioned around the periphery of the core. The monofilament optical fiber core can act either as a light emitter or receiver, and the outer peripheral optical fiber tube acts as the receiver for the emitter or vice versa. The emitter and receiver are insulated from each other, and an external imaging system sends a signal to one optical fiber conduit which produces an optical signal that reflects off the board. The other optical fiber conduit picks up the reflection from the board. The optical signal passes the fiducial marks and produces one type of reflection, whereas when the optical signal is centered on the fiducial marks, the reflections are interrupted and a different reflected light signal is sensed. Thus, the optical fiber and its imaging system acts as a transceiver to detect one type of light signal when there is misalignment with the fiducial mark and another type of light signal when alignment is produced.

Alternatively, the optical sensing device of the optical fiber type can comprise a pair of side-by-side optical fibers for emitting and receiving light signals to detect the position of the fiducial marks.

FIG. 9 illustrates another embodiment of a sensor 30 which comprises a pair of fiber optic probes 66 mounted to a fixture in alignment with fiducial marks on the board 20. The fiber optic probes are preferably flexible image conduits each comprising as many as 80,000 pixels, to transmit an image of the fiducial mark to the exterior of the fixture for further processing. The fixture in FIG. 9 also shows flexible optical fiber image conduits 68 transmitting images to remote display systems. In aligning the printed circuit board 20 to the fixture, the board is mounted on the tooling pins 24. The fiber optic probes 66 can be spring biased for spring-pressure contact with the underside of the board, or they can be used in combination with a lens system to focus on the fiducial marks on the board under test. Each of the tooling pins 24 is loosened, allowing the board to be moved manually relative to the fixture base and probes 18. This moves each fiducial mark relative to its corresponding optical sensor 30. Preferably, alignment is carried out by adjusting the position of one tooling pin until its related fiducial mark is properly aligned with a corresponding cross-hair (zero tolerance error reference point) on the monitor, and then adjusting the position of the other tooling pin to move its related fiducial mark into alignment with its related cross-hair. The external optical position detecting and imaging system can include retroreflective optical sensors for receiving external light signals conducted by the fiber optic probes. The underside of the board under test can be covered by a solder mask that reflects a given color of light picked up by the optical fiber sensors. The fiducial marks can be visible through the solder mask. The optical sensors on the external unit receive an external optical signal which is displayed in one color on the screen of a monitoring device from light reflected from the solder mask. When the fiducial marks are sensed by the optical fiber sensors (from movement of the board into the proper alignment position), the optical light signals change to a different color indicating alignment of the optical sensors with the respective fiducial marks. Alignment of each fiducial mark with a corresponding optical sensor is indicated on the imaging system, after which each tooling pin on the fixture is locked in a fixed position on the fixture base, for holding the board in its correctly aligned position.

In an alternative imaging system, a fiber optic probe 66 focuses on a fiducial mark and the opposite end of each optical probe is plugged into a second camera lens system used in displaying the fiducial mark on a remote monitor.

In another form of the invention, each optical sensor 30 can comprise a corresponding bore scope for producing a visual image of the location of the fiducial marks 28 relative to a known indexing mark produced by the external optical detecting and imaging system. The bore scope can be a type of optical detector using a matrix of optical fibers similar to pixels that form an image of an object in the field of view of the bore scope sensor. The bore scope is set at a fixed distance from the underside of the board because it has a fixed focal length lens to focus the light reflected from its field of view.

To properly align the board with the fixture, the board is placed on the tooling pins so that the board can be held at the correct set distance from each bore scope or other focusing optical device. The tooling pins are loosened at first so that the board can be moved manually relative to the fixture when the bore scope or other optical device is used for sighting the fiducial marks on the board. (The rectangular gasket 14 on which the board rests has sufficient clearance to allow shifting of the board relative to the top plate 16 and the probe field.) The board is then aligned using the imaging system which is best understood by referring to FIGS. 7 and 8. Each fiducial mark 28 is viewed through an eyepiece 54 which displays a cross-hair or other fixed zero reference indication generated in the optical display system. When the board is moved to position the fiducial mark close to the field of view, the bore scope or other optical device picks up the image of the fiducial mark which can be viewed in the eyepiece in reference to the fixed zero reference mark. The fiducial mark and the fixed reference mark can be enlarged and displayed on the screen of a video monitor 56 for use in accurately positioning the board on the fixture. The image enlarging and display system can include an image adapter 58 which senses the visual output from each eyepiece and adapts the images from both bore scopes into a display showing each fiducial mark in relation to its corresponding fixed zero reference cross-hair. The output from the image adapter is applied to a video enlarger 60 for enlarging the image of each reference cross-hair with its corresponding fiducial mark. An external camera 62 receives the image enlarger output for transmission to the video display terminal 56. FIG. 8 illustrates the video output on a screen of the video unit 56 which includes the enlarged image of a fiducial mark 28 detected by the optical sensor 30 in relation to a fixed zero reference cross-hair 64 in the imaging system.

By moving the circuit board relative to the fixture via the movable tooling pins, the position of each fiducial mark can be aligned with respect to its corresponding fixed reference mark 64. The screen of the video unit 56 can be observed as each tooling pin is manually moved through its 360° freedom of rotation until the fiducial marks on the board and the two sets of cross-hairs are properly registered. Each tooling pin is then locked in place on the fixture to automatically and precisely align the test points of the circuit array on the board with the test probes 18 on the fixture. The display shown in FIG. 8 is duplicated on a separate monitor for each fiducial mark and its related zero reference cross-hair. The board is moved while simultaneously monitoring all displays until all fiducial marks are aligned.

There are several possible means for setting the imaging system's fixed reference mark (the cross-hair 64) at a known zero position that will automatically align the test probes with the circuit array on the board when the image of the fiducial mark on the board is aligned with the image of the cross-hair reference. The preferred procedure is to use the calibration board, also referred to previously as a "gold board," which represents a zero alignment error when mounted to the test fixture. The gold board generates a zero alignment error with the test probes when tooling pins at diagonally opposite corners of the gold board are fitted into corresponding holes located on the test fixture at known fixed positions relative to the probe field. The external imaging system contains an electronically adjustable cross-hair generator to align separate cross-hairs with the reference marks or pins on the gold board so that zero alignment error is produced within the imaging system. This zero tolerance error is then calibrated electronically into the cross-hair imaging system. During testing, the gold board is replaced with each board under test, and enlarged images of the fiducial marks on a board being tested are displayed. The tooling pins on the fixture are loosened and each board is then moved to a position that will align its fiducial marks with the fixed reference cross-hairs set by the calibration system, to automatically align each board to the probe field on the fixture.

The image adapter is preferably arranged to display each tooling pin position reference with respect to a corresponding fiducial mark, as depicted in FIG. 8, in which case a separate monitor is used for each fiducial mark alignment; or a split screen arrangement can be used in which both sets of reference cross-hairs and fiducial marks are displayed on one screen.

FIGS. 10 and 11 illustrate a further embodiment of an optical sensor and alignment system in which each optical sensor 30 comprises a separate miniature camera lens and video probe assembly 70 mounted to the fixture, adjacent the probe field, for viewing toward the board under test. The separate camera lens and video probe assemblies each are removably mounted to the fixture base. Each assembly includes a lens, optical fiber image conduit, light source, video camera, image enlarging lens and connection to an external video monitor, all of which are removable from the fixture base. This arrangement enhances interchangeability with other fixtures.

Each camera lens and video probe assembly 70 includes a narrow cylindrical camera lens and optical fiber image conduit 72 mounted to a video camera 74. The image conduit 72 is comprised of a bundle of thousands (in one embodiment, 80,000) pixels or optical fibers in a manner similar to the optical probes 66 described previously. The lens and image conduit 72 are mounted in an elongated tubular video probe receptacle 76 affixed to the fixture base 25. The camera lens, optical conduit and video probe assembly extends downwardly under the base 25 of the fixture and into a hollow interior region 78 of the fixture housing. The camera lens, optical conduit and video probe assemblies mount to diagonally opposite corners of the base for alignment with corresponding fiducial marks on the underside of the board under test. The optical fiber image conduit 72 of each video probe and its corresponding lens are aligned with a separate enlarged hole 80 in opposite corners of the probe panel 16, for focusing on corresponding fiducial marks on the board. FIG. 11 illustrates how the fixture base 25 can pivot to an open position to gain access to the hollow interior region 78 of the fixture housing for mounting the camera and video probe assemblies in the receptacles 76 affixed to the base.

The fixturing arrangement shown in FIGS. 10 and 11 represents one embodiment in which the camera lens and video probe assemblies 70 are mounted inside the fixture housing, below the circuit board under test. The fixturing arrangement shown in FIG. 9 represents an alternative embodiment in which the camera lens and video probe assemblies may be remotely located from the fixture (because of space limitations), in which case the flexible optical fiber image conduits extend remotely away from the fixture for coupling to corresponding camera probes.

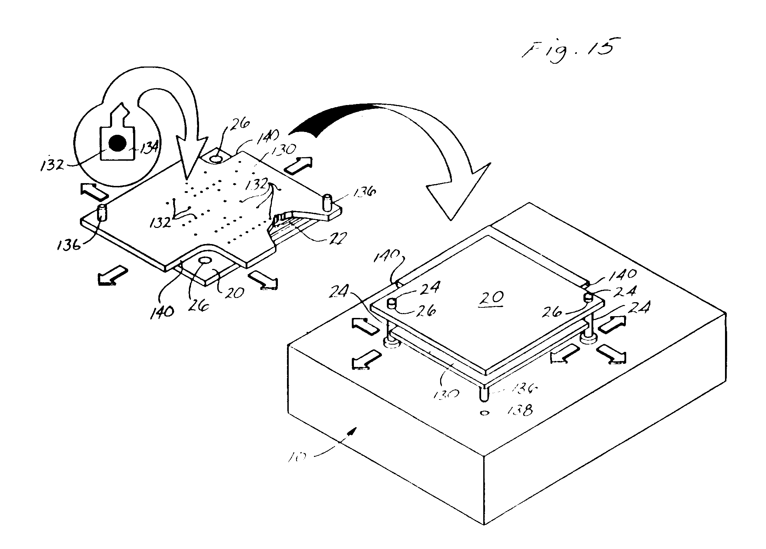

FIGS. 12 and 13 best illustrate the detailed construction of the camera lens and video probe assembly 70. The front of the optical fiber image conduit 72 has a double convex lens assembly 82 mounted in an opaque shield tube 84. A steel tube spacer 86 mounted behind the double convex lens provides an F-stop for the lens in focusing the image on the optical fiber image conduit. The lens assembly and optical fiber image conduit are mounted in an upright opaque lens tube 88 held in an opening through a lens mount 90 at the front of a video camera housing 92. The outer lens tube 91 carries a lock nut 93 used for in removably mounting the lens and video probe assembly to the video probe receptacle 76 on the base. (Alternatively, the receptacle that holds the video probe to the fixture can removably snap-lock into position, with a detent that automatically orients the optical system rotationally so that movement of the board is translated into corresponding movement of the fiducial mark on the monitor.) The tubular receptacle 76 on the fixture base contains a tubular opaque fiber optic conduit 91 which surrounds and parallels the long lens tube 88. The two tubes are coaxially aligned, leaving an open annular space between the inner tube 82 and the tubular outer fiber optic conduit 91. A plurality of flexible optical fibers 94 (in one embodiment, 56 separate optical fibers) extend through the annular space inside the conduit 91, from near the front of the lens tube to a lamp housing 96 on the video probe housing 92. A lamp 98 is mounted in a lamp holder in a cavity in the housing 92. The optical fibers 94 are directed from the annular space within the coaxial tubes into the cavity within the lamp housing for illumination from the light source. This is represented schematically at 98 in FIG. 12. The optical fibers 94 transmit the light from the lamp to the tip of the camera lens for forming an optical fiber ring 100 (see FIG. 13) which surrounds the lens system of the camera. The optical fiber ring produces a source of illumination for lighting the surface of the board 16, which can be a board under test or the gold board used for calibrating fixture alignment. The camera lenses 82 focus on the fiducial mark and produce an enlarged image of the fiducial mark on the optical fiber image conduit, along an optical axis 101 through the camera lens tube 88. Alternatively, the optical fiber image conduit 72 can be replaced with a relay lens system for optically transmitting an image of the fiducial mark to the video camera.

The video probe 74 includes a pair of lenses 102 and 104 mounted in a tube 105 on the optical axis 101 extending from the opening to the camera lens assembly, through the optical fiber image conduit 72 and lens mount 90, and into the housing 92 of the video camera. The tube 105 is threaded for adjusting the position of the lenses on the lens mount 90 to control the distance between the camera lens 82 and the lenses 102 and 104. The lenses 102 and 104 in the video camera comprise an achromatic lens and a lens to correct for color aberrations. The lens pair receive the enlarged image of the fiducial mark from the optical fiber image conduit and produce an essentially 1:1 image focused on a charge-coupled device (CCD) chip 106 contained in the video probe unit. The CCD chip converts the image from the video lenses into digital information processed by a video display system shown in FIG. 14. The digital signals from the CCD chip are sent to a camera controller unit (CCU) 108 shown in FIG. 14 which also schematically illustrates the camera lens 82 and optical fiber image conduit 72, the video camera 74, and the fiber optic lamp housing 96 with a power supply 110 powering the fiber optic light source. A camera cable 112 transmits digital signals from the CCD chip in the video camera to the camera controller unit (CCU) 108. The video CCU 110 can be a unit such as the EC-202 or EM-102 sold by Elmo of Japan. The CCU is powered by a conventional AC power source through an AC adapter 114 such as the Elmo AC-E12 adapter. A coaxial video cable 116 from the CCU transmits video signals to a TV monitor 118. The camera lens and video probe produce an enlarged image of the fiducial mark 28 on the display screen of the TV monitor 118. Separately, the output of a cross-hair generator 120 is electronically coupled to the video cable 116 for superimposing a video image of the cross-hair 64 on the TV monitor. A cross-hair position controller 122 controls the position of the cross-hair on the monitor. The video camera and display system illustrated in FIG. 14 is repeated for each separate reference point or fiducial mark sensed on the circuit board. This arrangement includes a separate TV monitor for each video probe. Separately, a split screen can be used to simultaneously display fiducial marks and their related cross-hair reference.

In using the video camera system for aligning a circuit board to the probe field on the fixture, the fixture is first calibrated with the gold board. The video cameras are powered, and the video system produces enlarged video images of the gold pins that represent each one of the gold board's fiducial marks. Each cross-hair display is adjusted until the video images show the gold pins in alignment with the cross-hairs displayed on the monitors. The gold board is then removed, and circuit boards are tested one at a time on the fixture, with each fiducial mark on the board being displayed on a video monitor. If a fiducial mark is misaligned relative to its cross-hair image, the tooling pin positions are simply adjusted while moving the board relative to the probe field until the fiducial mark images come into alignment with the cross-hairs. The board is then precisely aligned to the probe field on the fixture.

The video camera alignment system produces a highly accurate means of adjusting circuit boards because alignment can be done rapidly. Since very minute position adjustments of the board are translated into greatly enlarged visual image position adjustments, board alignment is highly accurate. The miniature video camera assemblies can be part of a basic fixturing system which includes the fixture housing and the video display and monitor. Only a new probe plate and top plate need to be drilled for each board being tested, along with forming a gold board to calibrate the alignment. The camera assemblies then mount to the receptacles in the probe plate. The entire lens and video probe system for forming an enlarged image of the fiducial mark is removed from or mounted to the base.

FIG. 15 shows another embodiment of the invention which provides a system for aligning circuit boards to the test fixture without use of the optical sensing means and means for producing enlarged images of a fiducial mark and a cross-hair or other zero reference point. In the illustrated system, an indexing or reference board 130, similar to the gold board described previously, is produced to represent a board perfectly aligned to the test fixture. The reference board 130 has a pattern of indexing marks 132 representing locations of the test points in the circuit array on a board under test. A circuit board 20 to be tested is aligned with the reference board so that test points 134 in the circuits on the board under test are matched to or overlie the test points 132 printed on the reference board. Preferably, the reference board is transparent so that the test points of the board 20 can be viewed through the reference board to align the test points 132 of the reference board with the corresponding test points 134 of the circuits on the board under test. The two overlying boards are then affixed to one another to prevent relative movement between them. The reference board also has tooling pins 136 or other alignment means related accurately to the test points 132 on the reference board. The reference board tooling pins are positioned accurately on the reference board so that when the tooling pins 136 are aligned with tooling pin holes 138 in the fixture, the reference board alignment will represent a circuit board accurately aligned to the field of test probes on the fixture. The reference board also includes cut out regions 140 in diagonally opposite corners that correspond to location of the movable tooling pins 24 on the fixture. The left side of FIG. 15 shows the transparent reference board 130 overlaid on a circuit board 20 being tested, in which the test points 132 of the reference board are visually aligned with corresponding test points 134 in the circuits on the board under test. When the two boards are perfectly aligned and the two boards are fastened together to prevent relative movement, the two boards are then flipped over and mounted to the fixture as shown in the right side of FIG. 15 (in which the circuit board 20 and the reference board 130 are shown separated for clarity). The reference board is mounted to the fixture by inserting the tooling pins 136 of the reference board in the correctly aligned tooling pin holes 138 in the fixture. If there is any misalignment between the tooling pin holes 26 of the board under test and the artwork on the board, then the tooling pins 24 in the fixture will not accurately register with the tooling pin holes 26 on the board under test. In this event, the tooling pins 24 are loosened and moved to positions which will correctly register the tooling pins 24 with the tooling pin holes 26. The cut out regions 140 provide clearance for moving the tooling pins 24 to their aligned positions. After the circuit board is aligned to the test fixture, the reference board 130 can be removed, and all boards within the same lot can then be tested on the test fixture using the same tooling pin positions.

## Claims

1. A test fixture for testing a printed circuit board (20) in which the test fixture (10) comprises a base (25); an array of test probes (18) on the base (25) to be aligned with a pattern of test points in a circuit array (22) on the board (20), the circuit array being positioned on the board (20) with reference to one or more indexing marks (28) on the board; said indexing marks comprising a fiducial mark (28); and board mounting means (24) on the base for holding the board in a fixed position relative to the array of test probes (18) on the base; sensing means (30) for sensing the position of the fiducial mark (28) on the board as the board is held on the base by the board mounting means (24), to produce a measurement of the alignment or misalignment of the array of test probes (18) relative to the pattern of test points in the circuit array (22) on the board, **characterised in that** said sensing means is mounted in a fixed position on the base for sensing the position of the fiducial mark (28) on the board, in that the board mounting means (24) comprises a tooling pin (24) on the fixture (10) for engaging an alignment device (26) positioned on the board (20) and in alignment with the circuit array (22), to hold the board and its circuit array in a fixed position relative to the array of test probes (18) on the fixture (10) and means (44) for rigidly securing the tooling pin in a first position for holding the board in a fixed position to produce said sensing means measurement, the tooling pin being moveable relative to the fixed position of the sensing means to move the board relative to the array of test probes (18) to a second adjusted position to correct any misalignment of the circuit array (22) relative to the array of test probes and to produce a corresponding change in said sensing means measurement, said sensing means producing said output to indicate the precise movement of the board to the second adjusted position on the fixture necessary to align the sensing means with the fiducial mark (28), to thereby indicate precise alignment of the test probes with corresponding test points in the circuit array of the board.

2. Apparatus according to claim 1, **characterised in that** the sensing means comprise an optical fibre sensor (30), and further including a visual display responsive to an optical fibre sensor output for producing a visual display of said measurement.

3. Apparatus according to claim 1, **characterised in that** the sensing means comprise: a camera lens and video probe assembly (70); and means responsive to an output of the video probe assembly (70) for producing a visual reading of said measurement; and in which the visual reading is produced by means converting an output of the video probe to a video image representative of said alignment or misalignment.

4. Apparatus according to claim 3, **characterised in that** the camera lens and video probe are removably mounted to the fixture base (25).

5. Apparatus according to claim 1, **characterised in that** an enlarged image of the indexing mark is displayed on a video monitor for comparison with an electronically adjustable indexing mark (28) produced on the monitor to indicate the correct alignment position of the circuit array (22) relative to the probes (18).

6. Apparatus according to claim 5, **characterised in that** an enlarged image of the fiducial mark (28) is displayed on a video monitor for comparison with an adjustable indexing mark electronically produced on the monitor to indicate the correct alignment position of the probes relative to the circuit array.

7. Apparatus according to claim 1, **characterised in that** the board mounting means comprise a tooling pin mounting hole (26) in the fixture base (25) adapted to provide substantially 360° freedom of movement of the tooling pin relative to the sensing means (30) on the fixture base, and locking means (40) adapted to hold the tooling pin in a fixed adjusted position cn the fixture base (25) in the tooling pin hole (26).

8. Apparatus according to claim 1, **characterised in that** the sensing means comprise an image focusing and enlarging means which are removably mounted to a fixed position on the fixture base (25).

9. Apparatus according to claim 1, **characterised in that** the sensing means (30) comprise an optical fibre means mounted in a fixed position on the fixture base for sensing the indexing mark (28) on the board and producing a first image that represents the position of the indexing mark; means for producing a second image of a fixed reference point that represents a fixed reference position with which the indexing mark position can be aligned to correctly register the array of test probes (18) with the pattern of test points on the board (20); electrical control means for forming the second image on a monitor and for adjusting the position of the second image on the monitor to indicate a calibrated correct alignment of the test probes relative to the circuit array (22) on the board (20); the tooling pin (24) being rigidly held in said first position to hold the board in a fixed position when producing said first image, the tooling pin (24) being movable to said second adjusted position, to thereby move the board relative to the fixture to align the first and second images and thereby correctly align the array of test probes (18) with the pattern of test points.

10. Apparatus according to claim 1, **characterised in that** the sensing means (30) comprise separate optical image conduits (72) mounted in fixed positions spaced apart on the fixture (10) for producing an image of each indexing mark (28) on the board (20); and including video means aligned with each optical image conduit (72) for producing separate enlarged video images of each indexing mark on a video monitor when the board is in said fixed position; and electrical control means for independently adjusting the positions of corresponding fixed reference points displayed on a video monitor for representing correct alignment of the test probes relative to the test points on the board, the position of the board mounting means on the base being adjustable to move the printed circuit board relative to the fixture base and relative to the fixed positions of the optical image conduits thereon to move the board to a corrected position to thereby move the images of the indexing marks into alignment with said corresponding fixed reference points, thereby aligning the test points on the board with corresponding test probes on the fixture.

11. Apparatus according to claim 10, **characterised in that** the video means include a video camera and a video cable for transmitting electronic video image signals from each video camera to a video monitor, and a separate reference point generator having a signal input to the video cable for superimposing an image of the reference point on the video monitor for adjustable alignment with the image of the fiducial mark produced by the video camera.

12. A method for testing a printed circuit board (20) having an array of test points in an circuit array (22) aligned on the board with reference to a fiducial mark (28) on the board (20), the method including mounting the board to a fixture base (25) having an array of probes (18) for contact with corresponding test points in the circuit on the board; producing an optical image of the fiducial mark (28) from an optical sensor (30) mounted on the fixture base (25) adjacent to the array of test probes (18); and producing on a monitor a fixed reference indication representative of accurate alignment of the circuit test points and the test probes; **characterised by** mounting the optical sensor (30) in a fixed position on the fixture base (25), and moving the printed circuit board (20) relative to the fixture base (25) and the fixed optical sensor (30) by using a tooling pin, which engages an alignment device (26) positioned on the board (20) and in alignment with the circuit array (22), to hold the board and its circuit array in a fixed position relative to the array of test probes (18) on the fixture (10), rigidly securing the tooling pin in a first position for holding the board in a fixed position to produce said optical image of the fiducial mark (28) from said optical sensor (30), moving the tooling pin relative to the fixed position of the optical sensor to move the board relative to the array of test probes (18) to a second adjusted position to correct any misalignment of the circuit array (22) relative to the array of test probes and to produce a corresponding change in said optical image of the fiducial mark (28) from said optical sensor (30), said optical sensor producing an output to indicate the precise movement of the board to the second adjusted position on the fixture, to bring the optical image of the fiducial mark (28) on the monitor into alignment with the fixed reference indication to accurately align the test points on the board with corresponding test probes on the fixture.

13. The method according to claim 12, **characterised in that** the optical image is produced by an optical fibre image conduit (72).

14. The method according to claim 12, **characterised in that** the optical image is produced by a lens system (82) for focusing on the fiducial mark and forming an enlarged image of the fiducial mark (28).

15. The method according to claim 14, **characterised by** calibrating the fixed reference indication by electronically adjusting the position of a reference indicator on a monitor and then moving the fiducial mark image into alignment with the fixed reference indication.

## Patentansprüche

1. Testvorrichtung zum Testen einer Leiterplatine (20), welche Testvorrichtung (10) ein Grundgestell (25) aufweist; mit einer Anordnung von Testsonden (18) auf dem Grundgestell (25), die mit einem Muster von Testpunkten in einer Schaltungsanordnung (22) auf der Platine (20) fluchtend ausgerichtet werden sollen, wobei die Schaltungsanordnung auf der Platine (20) bezüglich einer oder mehrerer Indizierungsmarken (28) auf der Platine angeordnet ist; welche Indizierungsmarken eine Bezugsmarke umfassen; und mit einer Platinenbefestigungseinrichtung (24) auf dem Grundrahmen zum Halten der Platine in einer festen Stellung relativ zur Anordnung von Testsensoren (18) auf der Grundplatte; einer Sensoreinrichtung (30) zum Aufnehmen der Position der Bezugsmarke (28) auf der Platine, wenn die Platine auf dem Grundrahmen durch die Platinenbefestigungseinrichtung (24) gehalten wird, um eine Messung des Fluchtens oder Nichtfluchtens der Anordnung von Testsonden (18) relativ zum Muster der Testpunkte in der Schaltungsanordnung (22) auf der Platine zu erzeugen, **dadurch gekennzeichnet,** daß die Sensoreinrichtung in einer festen Stellung auf dem Grundrahmen zum Aufnehmen der Position der Bezugsmarke (28) auf der Platine angebracht ist, daß die Platinenbefestigungseinrichtung (24) einen Werkzeugstift (24) auf der Vorrichtung (10) zum Eingriff einer Fluchtungsvorrichtung (26) umfaßt, welche auf der Platine (20) angeordnet ist und mit der Schaltungsanordnung (22) fluchtet, um die Platine und ihre Schaltungsanordnung in einer festgelegten Position relativ zur Anordnung der Testsonden (18) auf der Vorrichtung (10) zu halten und Einrichtungen (44) zum festen Sichern des Werkzeugstiftes in einer ersten Stellung aufweist zum Halten der Platine in einer festen Stellung, um die Messung der Sensoreinrichtung zu erzeugen, wobei der Werkzeugstift beweglich ist relativ zur festen Stellung der Sensoreinrichtung, um die Platine relativ zu der Anordnung von Testsonden (18) in eine zweite festgelegte Stellung zu bewegen, um jegliche Fluchtungsfehler der Schaltungsanordnung (22) relativ zu der Anordnung von Testsonden zu korrigieren, und um eine entsprechende Änderung in der Sensoreinrichtungsmessung zu erzeugen, wobei die Sensoreinrichtung die Ausgabe erzeugt, um die genaue Bewegung der Platine zur zweiten festgelegten Stellung auf der Vorrichtung anzugeben, die notwendig ist, um die Sensoreinrichtung mit der Bezugsmarke (28) fluchtend auszurichten, um dabei das genaue Fluchten der Testsonden mit zugehörigen Testpunkten in der Schaltungsanordnung auf der Platine anzugeben.

2. Apparat nach Anspruch 1, **dadurch gekennzeichnet,** daß die Sensoreinrichtung einen optischen Fasersensor (30) aufweist und darüber hinaus eine visuelle Anzeigeeinrichtung beinhaltet, die auf eine optische Fasersensorausgabe anspricht, um eine visuelle Anzeige der Messung zu erzeugen.

3. Apparat nach Anspruch 1, **dadurch gekennzeichnet,** daß die Sensoreinrichtung aufweist: eine Kameralinse und eine Videosondenanordnung (70); und eine Einrichtung, die auf eine Ausgabe der Videosondenanordnung (70) anspricht, um ein visuelles Lesen der Messung zu erzeugen; und bei welchem die visuelle Lesung erzeugt wird durch eine Einrichtung, die eine Ausgabe der Videosonde in ein Videobild konvertiert, welches repräsentativ für das Fluchten oder Nichtfluchten ist.

4. Apparat nach Anspruch 3, **dadurch gekennzeichnet,** daß die Kameralinse und Videosonde abnehmbar auf dem Vorrichtungsgrundrahmen (25) angebracht sind.

5. Apparat nach Anspruch 1, **dadurch gekennzeichnet,** daß ein vergrößertes Bild der Indizierungsmarke auf einem Videomonitor zum Vergleichen mit einer elektronisch einstellbaren Indizierungsmarke (28) angezeigt wird, welche auf dem Monitor erzeugt wird, um die korrekte Fluchtungsstellung der Schaltungsanordnung (22) relativ zu den Sonden (18) anzugeben.

6. Apparat nach Anspruch 5, **dadurch gekennzeichnet,** daß das vergrößerte Bild der Bezugsmarke (28) auf dem Videomonitor zum Vergleichen mit einer einstellbaren Indizierungsmarke angezeigt wird, die elektronisch auf dem Monitor erzeugt wird, um die korrekte Fluchtungsstellung der Sonden relativ zur Schaltungsanordnung anzugeben.

7. Apparat nach Anspruch 1, **dadurch gekennzeichnet,** daß die Platinenbefestigungseinrichtung ein Werkzeugstiftbefestigungsloch (26) in dem Vorrichtungsgrundrahmen (25) aufweist, welches daran angepaßt ist, eine im wesentlichen 360° Bewegungsfreiheit des Werkzeugstiftes relativ zu der Sensoreinrichtung (30) auf dem Grundrahmen bereitzustellen, und eine Sperreinrichtung (40), die daran angepaßt ist, den Werkzeugstift in einer festgelegten eingestellten Stellung auf dem Vorrichtungsgrundrahmen (25) in dem Werkzeugstiftloch (26) zu halten.

8. Apparat nach Anspruch 1, **dadurch gekennzeichnet**, daß die Sensoreinrichtung eine Bildfokussier- und Vergrößerungseinrichtung aufweist, die entfernbar in einer festen Stellung auf dem Vorrichtungsgrundrahmen (25) angebracht ist.

9. Apparat nach Anspruch 1, **dadurch gekennzeichnet,** daß die Sensoreinrichtung (30) eine optische Fasereinrichtung aufweist, die in einer festen Stellung auf dem Vorrichtungsgrundrahmen zum Aufnehmen der Indizierungsmarken (28) auf der Platine und zum Produzieren eines ersten Bildes angeordnet ist, welches die Stellung der Indizierungsmarke repräsentiert; Einrichtungen zum Erzeugen eines zweiten Bildes eines festen Bezugspunktes, welcher eine feste Bezugsstellung repräsentiert, mit welcher die Indizierungsmarkenstellung fluchtend ausgerichtet werden kann, um die Anordnung von Testsonden (18) korrekte mit dem Muster von Testpunkten auf der Platine (20) in Eingriff zu bringen; ein elektrische Steuerungseinrichtung zum Bilden eines zweiten Bildes auf einem Monitor und zum Einstellen der Stellung des zweiten Bildes auf dem Monitor, um ein kalibriertes korrektes Fluchten der Testsonden relativ zur Schaltungsanordnung (22) auf der Platine (20) anzugeben; wobei der Werkzeugstift (24) starr in seiner ersten Stellung gehalten wird, um die Platine in einer festen Stellung zu halten, wenn das erste Bild erzeugt wird, wobei der Werkzeugstift (24) in eine zweite festgelegte Stellung beweglich ist, um dabei die Platine relativ zur Vorrichtung zu bewegen, um die ersten und zweiten Bilder und dadurch korrekt die Anordnung von Testsonden (18) mit dem Muster von Testpunkten fluchtend anzuordnen.

10. Apparat nach Anspruch 1, **dadurch gekennzeichnet,** daß die Sensoreinrichtung (30) getrennte optische Bildleitungen (72) aufweist, die in einer festen Stellung beabstandet von der Vorrichtung (10), zum Erzeugen eines Bildes von jeder Indizierungsmarke (28) auf der Platine (20) angebracht sind; und daß Videoeinrichtungen vorgesehen sind, die mit jeder optischen Bildleitung (72) fluchten, um getrennte vergrößerte Videobilder von jeder Indizierungsmarke auf einem Videomonitor zu erzeugen, wenn sich die Platine in der festen Stellung befindet; und elektrischen Steuerungseinrichtungen zum unabhängigen Justieren der Stellungen der entsprechenden festen Bezugspunkte, welche auf einem Videomonitor angezeigt werden zum Repräsentieren des korrekten Fluchtens der Testsonden relativ zu den Testpunkten auf der Platine, wobei die Stellung auf der Platinenbefestigungseinrichtung auf den Grundrahmen einstellbar ist, um die Leiterplatine relativ zum Vorrichtungsgrundrahmen und relativ zu den festgelegten Stellungen der optischen Bildleitungen darauf zu bewegen, um die Platine in eine korrigierte Stellung zu bewegen, um dabei die Bilder der Indizierungsmarken fluchtend mit den entsprechenden festen Bezugspunkten auszurichten, und dabei Testpunkte auf der Platine mit entsprechenden Testsonden auf der Vorrichtung fluchtend auszurichten.

11. Apparat nach Anspruch 10, **dadurch gekennzeichnet,** daß die Videoeinrichtung eine Videokamera und ein Videokabel aufweist zum Übertragen elektronischer Videobildsignale von jeder Videokamera zu einem Videomonitor, und einen separaten Bezugspunkterzeuger aufweist, der einen Signaleingang zum Videokabel zum Überlagern eines Bildes des Bezugspunktes auf dem Videomonitor zum einstellbaren fluchtenden Ausrichten mit dem Bild der Bezugsmarke, welches durch die Videokamera erzeugt wird.

12. Verfahren zum Testen einer Leiterplatine (20), die eine Anordnung von Testpunkten in einer Schaltungsanordnung (22) aufweist, die auf der Platine mit Bezug zu einer Bezugsmarke (28) auf der Platine (20) angeordnet ist, welches Verfahren das Anbringen der Platine auf einem Vorrichtungsgrundrahmen (25) umfaßt, der eine Anordnung von Sonden (18) für einen Kontakt mit entsprechenden Testpunkten in der Schaltung auf der Platine aufweist; Erzeugen eines optischen Bildes der Bezugsmarke (28) durch einen optischen Sensor (30), der auf dem Vorrichtungsgrundrahmen (25) angrenzend an die Anordnung von Testsonden (18) angebracht ist; und Erzeugen einer festen Bezugsangabe auf einem Monitor, die repräsentativ ist für ein genaues Fluchten der Schaltungstestpunkte und der Testsensoren; **dadurch gekennzeichnet,** daß ein optischer Sensor (30) in einer festen Stellung auf dem Vorrichtungsgrundrahmen (25) angebracht ist, und Bewegen der Leiterplatine (20) relativ zum Vorrichtungsgrundrahmen (25) und dem festen optischen Sensor (30) durch Verwenden eines Werkzeugstiftes, welcher in eine Fluchtungseinrichtung (26) eingreift, die auf der Platine (20) angeordnet ist und mit der Schaltungsanordnung (22) fluchtet, um die Platine und ihre Schaltungsanordnung in einer festen Stellung relativ zur Anordnung von Testsonden (18) auf der Vorrichtung (10) zu halten, wobei der Werkzeugstift in einer ersten Stellung starr gesichert ist, um die Platine in einer festen Stellung zu halten, um das optische Bild der Bezugsmarke (28) von dem optischen Sensor (30) zu erzeugen, Bewegen des Werkzeugstiftes relativ zur festen Stellung des optischen Sensors, um die Platine relativ zur Anordnung von Testsonden (18) in eine zweite festgelegte Stellung zu bewegen, um jegliches Nichtfluchten der Schaltungsanordnung (22) relativ zu der Anordnung von Testsonden zu korrigieren, und um eine entsprechende Änderung in dem optischen Bild der Bezugsmarke (28) von dem optischen Sensor (30) zu erzeugen, wobei der optische Sensor eine Ausgabe erzeugt, um die genaue Bewegung der Platine zur zweiten festgelegten Stellung auf der Vorrichtung anzugeben, um das optische Bild der Bezugsmarke auf dem Monitor in fluchtende Übereinstimmung mit dem festen Bezugsindikator zu bringen, um entsprechend genau die Testpunkte auf der Platine mit entsprechenden Testsonden auf der Vorrichtung fluchtend auszurichten.

13. Verfahren nach Anspruch 12, **dadurch gekennzeichnet,** daß das optische Bild durch eine optische Faserbildleitung (22) erzeugt wird.

14. Verfahren nach Anspruch 12, **dadurch gekennzeichnet,** daß das optische Bild erzeugt wird durch ein Linsensystem (82) zum Fokussieren auf die Bezugsmarke und zum Erzeugen eines vergrößerten Bildes der Bezugsmarke (28).

15. Verfahren nach Anspruch 14, **dadurch gekennzeichnet,** daß die feste Bezugsindikation kalibriert wird durch elektronisches Einstellen der Stellung eines Bezugsindikators auf einem Monitor und anschließendes Bewegen des Bezugsmarkenbildes fluchtend zu dem festen Bezugsindikator.

## Revendications

1. Dispositif d'essai destiné à vérifier une carte à circuit imprimé (20) dans lequel le dispositif d'essai (10) comprend une embase (25); un réseau de sondes d'essai (18) sur l'embase (25) devant s'aligner avec un modèle de points d'essai dans un réseau de circuit (22) sur la carte (20), le réseau de circuit étant positionné sur la carte (20) en faisant référence à un repère d'indexation (28) ou davantage sur la carte; lesdits repères d'indexation comprenant un repère de référence (28); et des moyens de fixation de carte (24) sur l'embase destinés à maintenir la carte en position fixe par rapport au réseau de sondes (18) sur l'embase; des moyens de détection (30) destinés à détecter la position du repère de référence (28) sur la carte lorsque la carte est maintenue sur l'embase par les moyens de fixation de carte (24), afin de produire une mesure de l'alignement correct ou d'un défaut d'alignement du réseau de sondes d'essai (18) par rapport au modèle de points d'essai dans le réseau de circuit (22) sur la carte,
caractérisé en ce que
lesdits moyens de détection sont montés en position fixe sur l'embase afin de détecter la position du repère de référence (28) sur la carte, en ce que les moyens de fixation de carte (24) comprennent un ergot (24) sur le dispositif d'essai (10) destiné à s'engager dans un dispositif d'alignement (26) positionné sur la carte (20) et en alignement avec le réseau de circuit (22) pour maintenir la carte et son réseau de circuit en position fixe par rapport au réseau de sondes d'essai (18) sur le dispositif d'essai (10) et des moyens (44) destinés à fixer solidement l'ergot dans une première position afin de maintenir la carte en position fixe pour produire la mesure des dits moyens de détection, l'ergot étant mobile par rapport à la position fixe des moyens de détection pour déplacer la carte par rapport au réseau de sondes d'essai (18) sur une seconde position réglée pour corriger tout défaut d'alignement du réseau de circuit (22) par rapport au réseau de sondes d'essai et pour produire une modification correspondante de la mesure des dits moyens de détection, lesdits moyens de détection produisant ladite sortie pour indiquer le mouvement précis de la carte vers la seconde position réglée sur le dispositif, nécessaire à l'alignement des moyens de détection avec le repère de référence (28), permettant ainsi d'indiquer l'alignement précis des sondes d'essai avec les points d'essai correspondants dans le réseau de circuit de la carte.

2. Dispositif selon la revendication 1, caractérisé en ce que les moyens de détection comprennent un détecteur à fibre optique (30), et de plus comprennent un afficheur visuel sensible à une sortie de détecteur à fibre optique afin de produire un affichage visuel de ladite mesure.

3. Dispositif selon la revendication 1, caractérisé en ce que les moyens de détection comprennent : un ensemble d'objectif de caméra et de sonde vidéo (70); et des moyens sensibles à une sortie de l'ensemble de sonde vidéo (70) afin de produire une lecture visuelle de ladite mesure; et dans lesquels la lecture visuelle est produite au moyen de la conversion d'une sortie de la sonde vidéo en image vidéo représentative du dit alignement ou du dit défaut d'alignement.

4. Dispositif selon la revendication 3, caractérisé en ce que l'objectif de caméra et la sonde vidéo sont montés de manière amovible sur l'embase de dispositif (25).

5. Dispositif selon la revendication 1, caractérisé en ce qu'une image agrandie du repère d'indexation est affichée sur un moniteur vidéo afin d'être comparée avec un repère d'indexation réglable électroniquement (28) produit sur le moniteur en vue d'indiquer la position correcte d'alignement du réseau de circuit (22) par rapport aux sondes (18).

6. Dispositif selon la revendication 5, caractérisé en ce qu'une image agrandie du repère de référence (28) est affichée sur un moniteur vidéo afin d'être comparée avec un repère d'indexation réglable produit de manière électronique sur le moniteur en vue d'indiquer la position correcte d'alignement des sondes par rapport au réseau de circuit.

7. Dispositif selon la revendication 1, caractérisé en ce que les moyens de fixation de carte comprennent un orifice de montage de l'ergot (26) sur l'embase de dispositif (25) adapté pour procurer essentiellement une liberté de mouvement sur 360° de l'ergot par rapport aux moyens de détection (30) sur l'embase du dispositif, et des moyens de verrouillage (40) adaptés pour maintenir l'ergot dans une position fixe réglée sur l'embase de dispositif (25) dans l'orifice de l'ergot (26).

8. Dispositif selon la revendication 1, caractérisé en ce que les moyens de détection comprennent des moyens de mise au point et d'agrandissement d'image qui sont montés de manière amovible en position fixe sur l'embase de dispositif (25).

9. Dispositif selon la revendication 1, caractérisé en ce que les moyens de détection (30) comprennent des moyens de fibre optique montés en position fixe sur l'embase de dispositif afin de détecter le repère d'indexation (28) sur la carte et de produire une première image qui représente la position du repère d'indexation; des moyens destinés à produire une seconde image d'un point fixe de référence qui représente une position fixe de référence avec laquelle la position de repère d'indexation peut être alignée afin de faire coïncider correctement le réseau de sondes d'essai (18) avec le modèle de points d'essai sur la carte (20); des moyens électriques de commande destinés à former la seconde image sur un moniteur et destinés à régler la position de la seconde image sur le moniteur afin d'indiquer un alignement correct étalonné des sondes d'essai par rapport au réseau de circuit (22) sur la carte (20); l'ergot (24) étant fermement maintenu dans ladite première position afin de maintenir la carte en position fixe lors de la production de ladite première image, l'ergot (24) étant mobile vers ladite seconde position réglée, déplaçant ainsi la carte par rapport au dispositif afin d'aligner les première et seconde images et d'aligner correctement ainsi le réseau de sondes d'essai (18) avec le modèle de points d'essai.

10. Dispositif selon la revendication 1, caractérisé en ce que les moyens de détection (30) comprennent des conducteurs optiques d'image séparés (72) montés dans des positions fixes séparées sur le dispositif (10) afin de produire une image de chaque repère d'indexation (28) sur la carte (20); et comprennent des moyens vidéo alignés sur chaque conducteur optique d'image (72) afin de produire des images vidéo agrandies séparées de chaque repère d'indexation sur un moniteur vidéo lorsque la carte est dans ladite position fixe; et des moyens électriques de commande destinés à régler de manière indépendante les positions de points de références fixes correspondants affichés sur un moniteur vidéo afin de représenter l'alignement correct des sondes d'essai par rapport aux points d'essai sur la carte, la position des moyens de fixation de carte sur l'embase étant réglables pour pouvoir déplacer la carte à circuit imprimé par rapport à l'embase du dispositif et par rapport aux positions fixes des conducteurs optiques d'image sur celle-ci afin de déplacer la carte dans une position correcte pour pouvoir mettre les images des repères d'indexation en alignement avec lesdits points de référence fixes correspondants, ce qui permet l'alignement des points d'essai sur la carte avec des sondes d'essai correspondantes sur le dispositif.

11. Dispositif selon la revendication 10, caractérisé en ce que les moyens vidéo comprennent une caméra vidéo et un câble vidéo destiné à transmettre des signaux électroniques d'image vidéo à partir de chaque caméra vidéo vers un moniteur vidéo, et un générateur de point de référence séparé ayant une entrée de signal vers le câble vidéo afin de superposer une image du point de référence sur le moniteur vidéo pour un réglage d'alignement à l'image du repère de référence produite par la caméra vidéo.

12. Procédé destiné à essayer une carte à circuit imprimé (20) comportant un réseau de points d'essai dans un réseau de circuit (22) alignés sur la carte en faisant référence à un repère de référence (28) sur la carte (20), le procédé comprenant le montage de la carte sur une embase de dispositif d'essai (25) comportant un réseau de sondes d'essai (18) pour entrer en contact avec des points d'essai correspondants dans le circuit de la carte; la production d'une image optique du repère de référence (28) en provenance d'un détecteur optique (30) monté sur l'embase du dispositif (25) et adjacent au réseau de sondes d'essai (18); et la production sur un moniteur d'une indication de référence fixe représentant l'alignement précis des points d'essai de circuit et des sondes d'essai; caractérisé par le montage du détecteur optique (30) dans une position fixe sur l'embase de dispositif (25), et le déplacement de la carte à circuit imprimé (20) par rapport à l'embase de dispositif (25) et au détecteur optique fixe (30) à l'aide d'un ergot qui s'engage dans un dispositif d'alignement (26) positionné sur la carte (20) et en alignement avec le réseau de circuit (22), afin de maintenir la carte et son réseau de circuit en position fixe par rapport au réseau de sondes d'essai (18) sur le dispositif (10), la ferme fixation de l'ergot dans une première position afin de maintenir la carte en position fixe pour produire ladite image optique du repère de référence (28) en provenance du dit détecteur optique (30), le déplacement de l'ergot par rapport à la position fixe du détecteur optique afin de déplacer la carte par rapport au réseau de sondes d'essai (18) vers une seconde position réglée afin de corriger tout défaut d'alignement du réseau de circuit (22) par rapport au réseau de sondes d'essai et de produire une modification correspondante dans ladite image optique du repère de référence (28) en provenance du dit détecteur optique (30), ledit détecteur optique produisant une sortie destinée à indiquer le mouvement précis de la carte vers la seconde position réglée du dispositif, afin d'amener l'image optique du repère de référence (28) sur le moniteur dans l'alignement de l'indication fixe de référence pour aligner avec précision les points d'essai sur la carte avec des sondes d'essai correspondantes sur le dispositif.

13. Procédé selon la revendication 12, caractérisé en ce que l'image optique est produite par un conducteur d'image à fibre optique (72).

14. Procédé selon la revendication 12, caractérisé en ce que l'image optique est produite par un système d'objectif (82) pour une mise au point du repère de référence et la formation d'une image agrandie du repère de référence (28).

15. Procédé selon la revendication 14, caractérisé par l'étalonnage de l'indication fixe de référence par réglage électronique de la position d'un indicateur de référence sur un moniteur, et, ensuite, par le déplacement de l'image de repère de référence en alignement avec l'indication fixe de référence.
